# EUROPEAN PATENT APPLICATION

(11) **EP 2 565 945 A1**
(43) Date of publication of application: **06.03.2013**
(21) Application number: 11774673.5
(22) Date of filing: 10.02.2011
(51) Int. Cl.: H01L 33/44

(54) **SEMICONDUCTOR LIGHT-EMITTING ELEMENT, PROTECTIVE FILM FOR SEMICONDUCTOR LIGHT-EMITTING ELEMENT, AND PROCESS FOR PRODUCTION OF THE PROTECTIVE FILM**

(30) Priority: 28.04.2010 JP 2010104442
(71) Applicant: Mitsubishi Heavy Industries, Ltd., Tokyo 108-8215 (JP)
(72) Inventor: KAFUKU Hidetaka, Tokyo 108-8215 (JP); NISHIMORI Toshihiko, Tokyo 108-8215 (JP); KAWASAKI Hisao, Tokyo 108-8215 (JP)
(74) Representative: HOFFMANN EITLE
(86) International application number: PCT/JP2011/052813
(87) International publication number: WO 2011/135888

(57) **Abstract**

Disclosed are: a semiconductor light-emitting element which fulfills all of high migration preventing properties, high permeability and low film production cost; a protective film for a semiconductor light-emitting element; and a process for producing the protective film. In a semiconductor light-emitting element comprising multiple semiconductor layers (12-14) formed on a substrate (11) and electrode portions (15, 16) and electrode portions (17, 18) which act as electrodes for the multiple semiconductor layers (12-14), an SiN film (31) having a thickness of 35 nm or more and comprising silicon nitride covers the surrounds of the multiple semiconductor layers (12-14), the electrode portions (15, 16) and the electrode portions (17, 18) and an SiO film (32) having a higher thickness than that of the SiN film (31) and comprising silicon oxide covers the surround of the SiN film (31), as protective films for the semiconductor light-emitting element.

## Description

### TECHNICAL FIELD

The present invention relates to a semiconductor light-emitting element, a protective film of the semiconductor light-emitting element, and a method for producing the protective film.

### BACKGROUND ART

As semiconductor light-emitting elements, white LEDs (Light Emitting Diodes) capable of achieving energy saving and a long life are being expected as new indoor and outdoor illumination materials.
Patent Document 1: Japanese Patent Application Publication No. 2006-041403
Patent Document 2: Japanese Patent Application Publication No. 2007-189097

### DISCLOSURE OF THE INVENTION

### PROBLEM TO BE SOLVED BY THE INVENTION

At present, white LEDs capable of achieving both energy saving and a long life are limited to those of a power-saving type. Thus, to replace existing illuminations with such white LEDs while taking advantage of their low energy consumption and long life, multiple low-output LED chips must be used. This has been a cause of increase in cost.

To reduce the number of LED chips used in the illumination, the light output per chip needs to be increased. However, introducing a high power to the element accelerates the migration of Ag used in electrode portions thereof. This increases the likelihood of the occurrence of a short circuit and thus lowers the reliability of the element. Thus, it is necessary to suppress the migration of Ag in order for a high-output element to be reliable.

The migration of Ag accelerates upon its reaction with moisture. Hence, using a protective film which protects Ag from moisture for an LED element can suppress the migration and is therefore effective in improving the reliability of a high-output element. Meanwhile, this protective film is required to have high light transmittance so that light generated inside the element can be taken out effectively to the outside of the element.

Now, as Conventional Example 1, an LED element structure of Patent Document 1 is shown in Fig. 5, and a problem thereof will be described. Note that in Fig. 5, reference numeral 61 denotes a substrate; 62, an n-type semiconductor layer; 63, an active layer; 64, a p-type semiconductor layer; 65, a p-electrode; 66, a p-pad; 67, an n-electrode; 68, an n-pad; 71, a SiN film; and 72, a SiO film. The p-electrode 65 has a multilayer structure of Ag/Ni/Pt. Moreover, the arrows in the drawing show how light is transmitted.

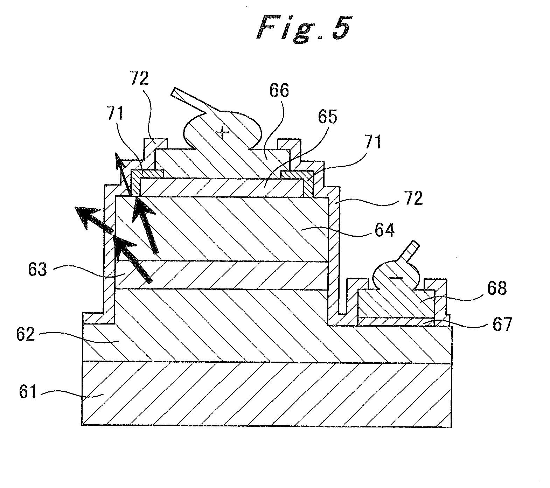

In the conventional LED element structure shown in Fig. 5, as a protective film, the SiN film 71 with high moisture resistance is used only around the p-electrode 65 and the SiO film 72 is then formed over the whole area. In this element structure, since the SiN film 71 is to be formed only around the p-electrode 65, it is necessary to perform a process of partially removing the SiN film 71 which is formed over the whole area, before the film formation of the SiO film 72. This increases the film formation cost. Moreover, in a case where Ag in the p-electrode 65 is diffused to lateral surfaces of the semiconductors, migration is likely to progress because the SiO film 72 is low in moisture resistance. Additionally, in general, since the SiN film 71 is lower in light transmittance than the SiO film 72, the transmittance drops around the p-electrode 65, hence lowering the efficiency of light extraction to the outside.

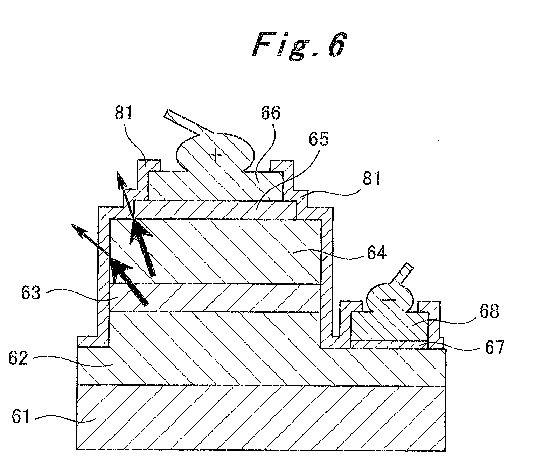

Next, as Conventional Example 2, an LED element structure of Patent Document 2 is shown in Fig. 6, and the problem thereof will be described. Note that in Fig. 6, the same components as those in Fig. 5 are denoted by the same reference numerals. Moreover, the arrows in the drawing show how light is transmitted. Note that reference numeral 81 denotes a SiN film.

In the conventional LED element structure shown in Fig. 6, the SiN film 81 with high moisture resistance is used over the whole element as a protective film. In this element structure, since the SiN film 81 with low transmittance covers the whole element, the efficiency of light extraction from the element to the outside is lowered. Additionally, in general, since the SiN film 81 has lower withstand voltage than SiO films, its film thickness needs to be large to secure its insulation performance. This increases the time required in the film formation and the cost of the film formation.

As described, in the conventional LED element structures, satisfying all of high migration prevention performance, high transmittance, and low film formation cost has been difficult, thus causing a problem in implementing a high-luminance structure.

The present invention has been made in view of the above problem, and an object thereof is to provide a semiconductor light-emitting element, a protective film of the semiconductor light-emitting element, and a method for producing the protective film, which satisfy all of high migration prevention performance, high transmittance, and low film formation cost.

### MEANS FOR SOLVING THE PROBLEMS

A protective film of a semiconductor light-emitting element according to a first aspect for solving the above-described problem is a protective film for protecting a semiconductor light-emitting element including a plurality of semiconductor layers formed on a substrate and a plurality of electrode portions serving as electrodes of the plurality of semiconductor layers, comprising: a first protective film and a second protective film as the protective film, the first protective film covering a periphery of the plurality of semiconductor layers and a periphery of the plurality of electrode portions, the second protective film covering a periphery of the first protective film, wherein the first protective film is made of a silicon nitride and has a film thickness of 35 nm or larger, and the second protective film is made of a silicon oxide and has a film thickness larger than the film thickness of the first protective film.

A protective film of a semiconductor light-emitting element according to a second aspect for solving the above-described problem is the protective film of a semiconductor light-emitting element according to the first aspect, further comprising: a third protective film covering a periphery of the second protective film, wherein the third protective film is made of a silicon nitride and has a film thickness of 35 nm or larger.

A protective film of a semiconductor light-emitting element according to a third aspect for solving the above-described problem is the protective film of a semiconductor light-emitting element according to the second aspect, wherein the second protective film is made of a silicon oxide whose number of Si-OH bonds inside the film is 1.3×10²¹ [bonds/cm³] or smaller, in which case the film thickness of the first protective film is set to 17.5 nm or larger.

A protective film of a semiconductor light-emitting element according to a fourth aspect for solving the above-described problem is the protective film of a semiconductor light-emitting element according to any one of the first to third aspects, wherein at least one of the plurality of electrode portions is made of a metal containing silver.

A semiconductor light-emitting element according to a fifth aspect for solving the above-described problem uses the protective film of a semiconductor light-emitting element according to any one of the first to fourth aspects.

A method for producing a protective film of a semiconductor light-emitting element according to a sixth aspect for solving the above-described problem is a method for producing a protective film for protecting a semiconductor light-emitting element including a plurality of semiconductor layers formed on a substrate and a plurality of electrode portions serving as electrodes of the plurality of semiconductor layers, comprising: providing a first protective film and a second protective film as the protective film, the first protective film covering a periphery of the plurality of semiconductor layers and a periphery of the plurality of electrode portions, the second protective film covering a periphery of the first protective film, wherein the first protective film is formed from a silicon nitride to a film thickness of 35 nm or larger, and the second protective film is formed from a silicon oxide to a film thickness larger than the film thickness of the first protective film.

A method for producing a protective film of a semiconductor light-emitting element according to a seventh aspect for solving the above-described problem is the method for producing a protective film of a semiconductor light-emitting element according to the sixth aspect, further comprising: a third protective film covering a periphery of the second protective film, the third protective film being formed from a silicon nitride to a film thickness of 35 nm or larger.

A method for producing a protective film of a semiconductor light-emitting element according to an eighth aspect for solving the above-described problem is the method for producing a protective film of a semiconductor light-emitting element according to the seventh aspect, wherein the second protective film is formed from a silicon oxide whose number of Si-OH bonds inside the film is 1.3×10²¹ [bonds/cm³] or smaller, in which case the film thickness of the first protective film is set to 17.5 nm or larger.

A method for producing a protective film of a semiconductor light-emitting element according to a ninth aspect for solving the above-described problem is the method for producing a protective film of a semiconductor light-emitting element according to any one of the sixth to eighth aspects, wherein at least one of the plurality of electrode portions is made of a metal containing silver.

### EFFECT OF THE INVENTION

According to the present invention, the semiconductor light-emitting element can satisfy all of high migration prevention performance, high transmittance, and low film formation cost, thereby implementing a high-luminance structure.

### BRIEF DESCRIPTION OF THE DRAWINGS

[Fig. 1] Fig. 1 is a cross-sectional view showing an element structure of a semiconductor light-emitting element according to the present invention as an illustrative embodiment (Example 1).
[Fig. 2] Fig. 2 is a graph showing the relationship between the moisture resistance and the film thickness of a SiN film of the semiconductor light-emitting element shown in Fig. 1.
[Fig. 3] Fig. 3 is a cross-sectional view showing an element structure of a semiconductor light-emitting element according to the present invention as another illustrative embodiment (Example 2).
[Fig. 4] Fig. 4 is a cross-sectional view showing an element structure of a semiconductor light-emitting element according to the present invention as still another illustrative embodiment (Example 3).
[Fig. 5] Fig. 5 is a cross-sectional view showing a conventional LED element structure.
[Fig. 6] Fig. 6 is a cross-sectional view showing another conventional LED element structure.

### EXPLANATION OF THE REFERENCE NUMERALS

- 11: substrate
- 12: n-type semiconductor layer
- 13: active layer
- 14: p-type semiconductor layer
- 15: p-electrode (electrode portion)
- 16: p-pad (electrode portion)
- 17: n-electrode (electrode portion)
- 18: n-pad (electrode portion)
- 31, 41, 51: SiN film (first protective film)
- 32, 42, 52: SiO film (second protective film)
- 43, 53: SiN film (third protective film)

### BEST MODES FOR CARRYING OUT THE INVENTION

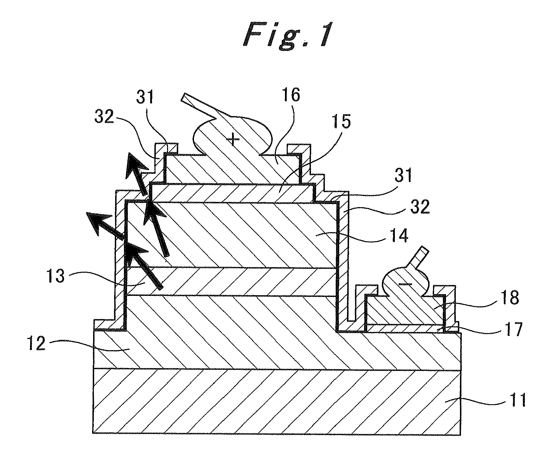

Hereinbelow, a semiconductor light-emitting element, a protective film of the semiconductor light-emitting element, and a method for producing the protective film according to the present invention will be described through some embodiments with reference to Figs. 1 to 4. Note that in each of examples given below, description will be given based on an instance where an LED is used as the semiconductor light-emitting element.

### (Example 1)

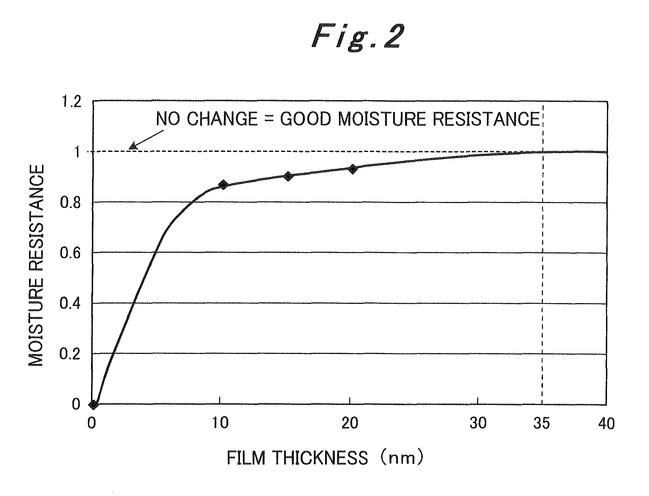

Fig. 1 is a cross-sectional view showing an LED element structure of this example. The arrows in the drawings show how light is transmitted. Moreover, Fig. 2 is a graph showing the relationship between the moisture resistance and the film thickness of a SiN film described later.

The LED of this example has an element structure with semiconductor layers obtained by sequentially stacking an n-type semiconductor layer 12 made of n-type GaN, an active layer 13 having a multiple quantum well structure obtained by alternately stacking GaN and InGaN, and a p-type semiconductor layer 14 made of p-type GaN, on a substrate 11 made of sapphire. Note that the n-type semiconductor layer 12 and the p-type semiconductor layer 14 have a structure including an n-type contact layer and a structure including a p-type contact layer, respectively.

Then, the p-type semiconductor layer 14, the active layer 13, and the n-type semiconductor layer 12 thus stacked are partially removed by etching to expose the n-type contact layer of the n-type semiconductor layer 12, and W and Pt are stacked on the exposed portion in this order from the semiconductor-layer side to form an n-electrode 17. On the other hand, Ag, Ni, and Pt are stacked on the upper surface of the p-type contact layer of the p-type semiconductor layer 14 in this order from the semiconductor-layer side to form a p-electrode 15. Moreover, a p-pad 16 made of Au and an n-pad 18 made of Au are formed on the p-electrode 15 and the n-electrode 17, respectively, so that bumps can be formed. As described, the pair of the p-electrode 15 and the p-pad 16 and the pair of the n-electrode 17 and the n-pad 18 serve as electrode portions for the stacked semiconductor layers, respectively.

In the element structure described above, a SiN film 31 (first protective film) made of a SiN having insulating properties is stacked in such a way as to cover the periphery of each semiconductor layer (the n-type semiconductor layer 12, the active layer 13, and the p-type semiconductor layer 14) and the periphery of each electrode portion (the pair of the p-electrode 15 and the p-pad 16 and the pair of the n-electrode 17 and the n-pad 18) except for openings on the p-pad 16 and the n-pad 18 for the bumps. Then, a SiO film 32 (second protective film) made of a SiO having insulating properties is stacked in such a way as to cover the periphery of the SiN film 31. In other words, formed is a protective film of a two-layer structure having the SiN film 31 as the first layer and the SiO film 32 as the second layer. Accordingly, the structure is such that the two-layer structure with the SiN film 31 and the SiO film 32 protects not only the periphery of the p-electrode 15 containing Ag but also the periphery of the whole element.

The SiN film 31 and the SiO film 32 are formed by a plasma CVD method. In particular, a plasma CVD method (apparatus) using high-density plasma is preferable. Note that it is possible to use some other method such for example as a sputtering method (apparatus) or a vacuum deposition method (apparatus) as long as similar SiN and SiO films can be formed.

As mentioned earlier, SiN protective films have a problem that they have high moisture resistance but have low transmittance and poor withstand voltage.

In this respect, in this example, the structure is such that the SiN film 31 is formed to have a film thickness with which the SiN film 31 can maintain its moisture resistance and that the SiO film 32 having poor moisture resistance but having high transmittance and high withstand voltage is stacked on the outer side of this SiN film 31.

Now, the relationship between the moisture resistance and the film thickness of the SiN film 31 will be described with reference to the graph in Fig. 2. Note that the moisture resistance in Fig. 2 refers to the moisture resistance of an evaluation target SiN film evaluated by sequentially forming the evaluation target SiN film and a SiO film, which has a large internal moisture content, on a cobalt-iron film as a sample and then measuring the magnetization decay of the cobalt and iron in the formed sample. In this case, the evaluation was made on a SiN film formed by a plasma CVD method.

As shown in the graph in Fig. 2, the moisture resistance drops as the film thickness becomes smaller when the film thickness of the SiN film is smaller than 35 nm, while the moisture resistance is good when the film thickness of the SiN film is 35 nm or larger. Thus, in the example, the film thickness of the SiN film 31 is set to be 35 nm or larger with which the SiN film 31 can secure its moisture resistance.

Moreover, the SiO film 32 is such that the total film thickness of itself and the SiN film 31 is set to a film thickness with which the element can be physically protected, that is, a film thickness with which the semiconductor layers of the element can be prevented from being scratched. Specifically, the total film thickness is set to 400 to 1000 nm which is used among general LEDs. Here, the film thickness of the SiO film 32 is set larger than the film thickness of the SiN film 31.

In the element structure described above, since the SiN film 31 covers the whole element except for some spots (the openings on the pads), the entry of moisture to the inside is prevented at the sidewall of the element, and thus the migration of Ag in the p-electrode 15 can be suppressed. Thereby, high migration prevention performance can be achieved. Moreover, since there is no need for the SiN film 31 to have a large film thickness or to be etched, the film formation cost can be reduced.

Table 1 shows the migration prevention performance, the transmittance, the film formation cost, and the feasibility of a high-luminance structure in comparison with those of Conventional Examples 1 and 2 mentioned earlier. Note that Table 1 also shows Examples 2 and 3 described later.

**[Table 1]**

| | Conventional Example 1 | Conventional Example 2 | Example 1 | Example 2 | Example 3 |
|---|---|---|---|---|---|
| Migration Prevention Performance | Poor | Excellent | Good | Excellent | Excellent |
| Light Transmittance | Good | Poor | Excellent | Good | Excellent |
| Film Thickness: 500 nm | 100% | 80 to 90% | 99.3% | 98.5% | 98.9% |
| Wavelength: 350 nm | (Note 1) | | | | |
| Film Formation Cost | Poor | Relatively Poor | Good | Good | Good |
| Feasibility of High-Luminance Structure | Relatively Poor | Relatively Poor | Good | Excellent | Excellent |

| | | | | | |
|---|---|---|---|---|---|
| (Note 1): 80 to 90% around the p-electrode due to the presence of the SiN film | | | | | |

As shown in Table 1, since the SiN film 31 covers the whole element, the migration prevention performance in this example is higher than that in Conventional Example 1. Thereby, the reliability of the element is improved.

Moreover, in comparisons under a condition that the film thickness and the wavelength of light are 500 nm and 350 nm, respectively (the film thickness and the transmittance of the SiN film 31 of this example are 35 nm and 90%, respectively), the transmittance in this example is 99.3% in terms of the transmittance of the whole protective film. This is higher than Conventional Example 2 and substantially the same as Conventional Example 1 (in a case of allowing for the transmittance around the p-electrode). Thereby, the light extraction efficiency is improved.

Furthermore, the film formation cost in this example is lower than Conventional Example 1 which requires an etching process and Conventional Example 2 in which the film thickness is large, because the protective film can have high withstand voltage due to the stacking of the SiO film 32, and the thickness of the whole protective film can be made small.

As described, this example can satisfy all of high migration prevention performance, high transmittance, and low film formation cost and therefore improves the feasibility of a high-luminance structure as compared to the conventional cases.

### (Example 2)

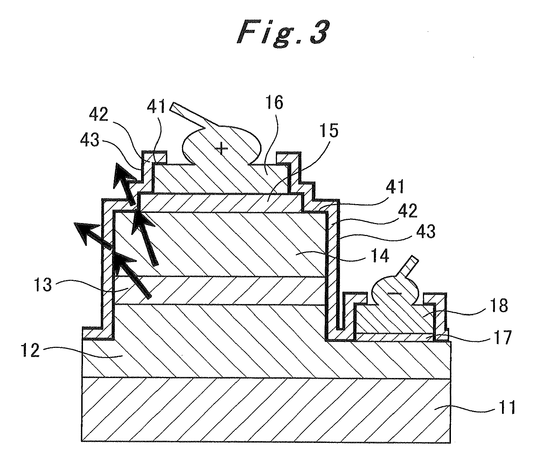

Fig. 3 is a cross-sectional view showing an LED element structure of this example. Note that in Fig. 3, the same components as the components described in Example 1 (see Fig. 1) are denoted by the same reference numerals, and overlapping description thereof is omitted. Moreover, the arrows in the drawing show how light is transmitted.

In the LED of this example, the element structure of the semiconductor layers has the same configuration as that of the LED described in Example 1 (see Fig. 1). Moreover, like Example 1, the protective film is formed in such a way as to cover the periphery of the semiconductor layers and the periphery of the electrode portions except for the openings on the p-pad 16 and the n-pad 18 for the bumps. However, the configuration of this protective film differs from that of Example 1.

Specifically, as the protective film, a SiN film 41 (first protective film), a SiO film 42 (second protective film), and a SiN film 43 (third protective film) are sequentially stacked. The SiN film 41 is made of a SiN having insulating properties. The SiO film 42 is made of a SiO having insulating properties. The SiN film 43 is made of a SiN having insulating properties. In other words, formed is a protective film of a three-layer structure having the SiN film 41 as the first layer, the SiO film 42 as the second layer, and the SiN film 43 as the third layer. Accordingly, the structure is such that the three-layer structure with the SiN film 41, the SiO film 42, and the SiN film 43 protects not only the periphery of the p-electrode 15 containing Ag but also the periphery of the whole element.

The SiN film 41, the SiO film 42, and the SiN film 43 are formed by a plasma CVD method. In particular, a plasma CVD method (apparatus) using high-density plasma is preferable. Note that it is possible to use some other method such for example as a sputtering method (apparatus) or a vacuum deposition method (apparatus) as long as similar SiN and SiO films can be formed.

As mentioned earlier, SiN protective films have a problem that they have high moisture resistance but have low transmittance and poor withstand voltage. Moreover, SiO protective films have such a nature that moisture easily passes therethrough and further is easily held therein. Thus, once such a film holds a large amount of moisture, the film becomes a source of moisture. This leads to a problem that even when a SiN protective film is formed on the inner side of the film, moisture permeates the SiN protective film and enters the element side, though only slightly, if the film thickness of the SiN protective film is small.

In this respect, in this example, the structure is such that the SiN film 41 is formed to have a film thickness of 35 nm or larger with which the SiN film 41 can maintain its moisture resistance as described in Fig. 2, that the SiO film 42 having poor moisture resistance but having high transmittance and high withstand voltage is stacked on the outer side of this SiN film 41, and that the SiN film 43 having a film thickness of 35 nm or larger with which the SiN film 43 can maintain its moisture resistance is further stacked on the outer side of the SiO film 42.

Moreover, the SiO film 42 is such that the total film thickness of itself, the SiN film 41, and the SiN film 43 is set to a film thickness with which the element can be physically protected, that is, a film thickness with which the semiconductor layers of the element can be prevented from being scratched. Specifically, the total film thickness is set to 400 to 1000 nm which is used among general LEDs. Here, the film thickness of the SiO film 42 is set larger than the film thickness of each of the SiN films 41 and 43.

In the element structure described above, since the SiN film 41 covers the whole element except for some spots (the openings on the pads), the entry of moisture to the inside is prevented at the sidewall of the element, and thus the migration of Ag in the p-electrode 15 can be suppressed. Thereby, high migration prevention performance can be achieved. Furthermore, in this example, since the SiN film 43 is further provided on the outer side of the SiO film 42, moisture entering the inside of the protective film, or the inside of the SiO film 42 in particular, can be reduced. Accordingly, moisture entering the element side can be reduced. As a result, the migration prevention performance can be improved further as compared to Example 1. Moreover, since there is no need for the SiN films 41 and 43 to have a large film thickness or to be etched as in the conventional case, the film formation cost can be reduced.

In addition, as shown in Table 1, the migration prevention performance in this example is higher than that in Conventional Example 1 and also higher than that in Example 1. Thereby, the reliability of the element is further improved.

Moreover, in comparisons under a condition that the film thickness and the wavelength of light are 500 nm and 350 nm, respectively (the film thickness and the transmittance of each of the SiN films 41 and 43 of this example are 35 nm and 90%, respectively), the transmittance in this example is 98.5% in terms of the transmittance of the whole protective film. This transmittance is slightly lower than Example 1 but higher than Conventional Example 2 and substantially the same as Conventional Example 1 (in a case of allowing for the transmittance around the p-electrode). Thereby, the light extraction efficiency is improved. Like Example 1, this is because each of the SiN films 41 and 43 having low transmittance has a small film thickness relative to the film thickness of the whole protective film while the SiO film 42 having high transmittance has a large film thickness, and therefore the protective film can achieve high transmittance as a whole.

Furthermore, the film formation cost in this example is slightly higher than that in Example 1 because the SiN film 43 is additionally stacked. However, the film formation cost in this example is lower than that in Conventional Example 1 which requires an etching process and that in Conventional Example 2 in which the film thickness is large, because the protective film can have high withstand voltage as a whole due to the stacking of the SiO film 42 and the thickness of the whole protective film can be made small.

As described, this example can satisfy all of high migration prevention performance, high transmittance, and low film formation cost and therefore improves the feasibility of a high-luminance structure as compared to the conventional cases.

### (Example 3)

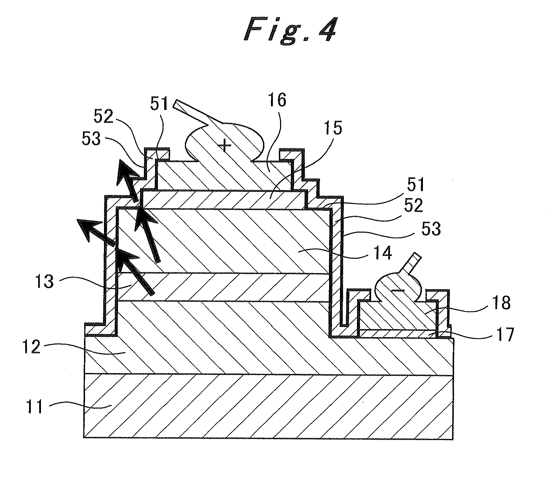

Fig. 4 is a cross-sectional view showing an LED element structure of this example. Note that in Fig. 4, the same components as the components described in Example 1 (see Fig. 1) are denoted by the same reference numerals, and overlapping description thereof is omitted. Moreover, the arrows in the drawing show how light is transmitted.

In the LED of this example, the element structure of the semiconductor layers has the same configuration as that of the LED described in Example 1 (see Fig. 1). Moreover, like Example 1, the protective film is formed in such a way as to cover the periphery of the semiconductor layers and the periphery of the electrode portions except for the openings on the p-pad 16 and the n-pad 18 for the bumps. However, the configuration of this protective film differs from that of Example 1. Further, the protective film differs from that of Example 2 in the film properties of the SiO film.

Specifically, as the protective film, a SiN film 51 (first protective film), a SiO film 52 (second protective film), and a SiN film 53 (third protective film) are sequentially stacked. The SiN film 51 is made of a SiN having insulating properties. The SiO film 52 is made of a SiO having insulating properties and a small internal moisture content. The SiN film 53 is made of a SiN having insulating properties. In other words, formed is a protective film of a three-layer structure having the SiN film 51 as the first layer, the SiO film 52 as the second layer, and the SiN film 53 as the third layer. Accordingly, the structure is such that the three-layer structure with the SiN film 51, the SiO film 52, and the SiN film 53 protects not only the periphery of the p-electrode 15 containing Ag but also the periphery of the whole element.

The SiN film 51, the SiO film 52, and the SiN film 53 are formed by a plasma CVD method. In particular, a plasma CVD method (apparatus) using high-density plasma is preferable. Note that it is possible to use some other method such for example as a sputtering method (apparatus) or a vacuum deposition method (apparatus) as long as similar SiN and SiO films can be formed.

As mentioned earlier, SiN protective films have a problem that they have high moisture resistance but have low transmittance and poor withstand voltage. Moreover, SiO protective films have such a nature that moisture easily passes therethrough and further is easily held therein. Thus, once such a film holds a large amount of moisture, the film becomes a source of moisture. This leads to a problem that even when a SiN protective film is formed on the inner side of the film, moisture permeates the SiN protective film and enters the semiconductor-layer side, though only slightly, if the film thickness of the SiN protective film is small.

In this respect, in this example, a SiO film having a small internal moisture content is used as the SiO film 52 in the three-layer structure formed of the SiN film 51, the SiO film 52, and the SiN film 53. Specifically, the SiO film should have film properties which make the number of Si-OH bonds thereof (found based on the peak area of Si-OH bonds present around 3738 cm⁻¹) equal to or lower than 1.3×10²¹ [bonds/cm³] in a measurement using an IR analysis (infrared analysis). If so, the moisture content in the film should also show a sufficiently low value in a measurement using thermal desorption spectroscopy (TDS). Table 2 given below shows comparisons between the normal SiO film used in each of Examples 1 and 2 and the SiO film with a low moisture content used in this example. While the number of Si-OH bonds and moisture content of the normal SiO film are 2.6×10²¹ [bonds/cm³] and 2.6×10²¹ [molecules/cm³], respectively, those of the low-moisture SiO film of this example are both 1/2 of the above values.

**[Table 2]**

| | Normal SiO Film | Low-Moisture SiO Film |
|---|---|---|
| Moisture Content (TDS) [molecules/cm³] | 2.6×10²¹ | 1.3×10²¹ |
| Number of Si-OH Bonds (IR) [bonds/cm³] | 2.6×10²¹ | 1.3×10²¹ |

In Example 2, since the SiN film 43 is provided in the third layer, moisture hardly enters the SiO film 42 from the outside. However, since the SiO film 42 naturally contains a large amount of moisture, the SiN film 41 in the first layer for preventing the diffusion of moisture from the SiO film 42 to the element side cannot have a small film thickness. In contrast, since the internal moisture content of the SiO film of this example is 1/2 of that of the normal SiO film as shown in Table 2, the SiN film 51 for preventing the diffusion of moisture to the element side can be made thin. Specifically, 35 nm, which is the minimum film thickness with which the SiN film 51 can maintain its moisture resistance as described in Fig. 2, can be reduced by 1/2 to 17.5 nm. Accordingly, higher transmittance than Example 2 can be achieved.

Moreover, this example too has a three-layer structure in which the SiO film 52 having high transmittance and high withstand voltage is stacked on the outer side of the SiN film 51, and further the SiN film 53 is stacked on the outer side of the SiO film 52. However, the SiN film 51 is formed to have a film thickness of 17.5 nm or larger as described above due to the small internal moisture content of the SiO film 52. Further, the structure is such that the SiN film 53 having a film thickness of 35 nm or larger with which the SiN film 53 can maintain its moisture resistance as described in Fig. 2 is stacked on the outer side of the SiO film 52.

Furthermore, the total film thickness of the SiN film 51, the SiO film 52, and the SiN film 53 is set to a film thickness with which the element can be physically protected, that is, a film thickness with which the semiconductor layers of the element can be prevented from being scratched. Specifically, the total film thickness is set to 400 to 1000 nm which is used among general LEDs. Here, the film thickness of the SiO film 52 is larger than the film thickness of each of the SiN films 51 and 53.

In the element structure described above, since the SiN film 51 covers the whole element except for some spots (the openings on the pads), the entry of moisture to the inside is prevented at the sidewall of the element, and thus the migration of Ag in the p-electrode 15 can be suppressed. Thereby, high migration prevention performance can be achieved. In this example, the film thickness of the SiN film 51 is smaller than that of the SiN film 41 of Example 2 but the internal moisture of the SiO film 52 itself is small in amount as mentioned above. Thereby, sufficiently high migration prevention performance can be achieved. Further, in this example, since the internal moisture content of the SiO film 52 is low, and the SiN film 53 is further provided on the outer side thereof, moisture entering the inside of the protective film, or the inside of the SiO film 52 in particular, can be reduced. Accordingly, moisture entering the element side can be reduced. As a result, the migration prevention performance can be improved further as compared to Example 1. Moreover, since there is no need for the SiN films 51 and 53 to have a large film thickness or to be etched, the film formation cost can be reduced.

In addition, as shown in Table 1, the migration prevention performance in this example is higher than that in Conventional Example 1 and also higher than that in Example 1. Thereby, the reliability of the element is further improved.

Moreover, in comparisons under a condition that the film thickness and the wavelength of light are 500 nm and 350 nm, respectively (the film thickness and the transmittance of each of the SiN films 51 and 53 of this example are 35 nm and 90%, respectively), the transmittance in this example is 98.9% in terms of the transmittance of the whole protective film. This transmittance is slightly lower than Example 1 but slightly higher than Example 2, higher than Conventional Example 2, and substantially the same as Conventional Example 1 (in a case of allowing for the transmittance around the p-electrode). Thereby, the light extraction efficiency is improved. Like Examples 1 and 2, this is because each of the SiN films 51 and 53 having low transmittance has a small film thickness relative to the film thickness of the whole protective film while the SiO film 52 having high transmittance has a large film thickness, and therefore the protective film can achieve high transmittance as a whole.

Furthermore, the film formation cost in this example is slightly higher than that in Example 1 because the SiN film 53 is additionally stacked. However, the film formation cost in this example is slightly lower that in than Example 2 because the SiN film 51 has a small film thickness. Also, the film formation cost in this example is lower than that in Conventional Example 1 which requires an etching process and that in Conventional Example 2 in which the film thickness is large, because the protective film can have high withstand voltage as a whole due to the stacking of the SiO film 52 and the thickness of the whole protective film can be made small.

As described, this example can satisfy all of high migration prevention performance, high transmittance, and low film formation cost and therefore improves the feasibility of a high-luminance structure as compared to the conventional cases.

Note that the materials and configurations of the semiconductor layers of the LEDs in Examples 1 to 3 described above are not limited to the materials and the configurations described above, and may be different materials and configurations. For example, each semiconductor layer may be made of a nitride semiconductor composed of a group III element such as In, Al, or Ga, and a group V element such as N, or the like. Moreover, the structure of the active layer 13 is not limited to a multiple quantum well structure and may be a single quantum well structure, a strained quantum well structure, or the like. Moreover, the substrate 11 is not limited to a sapphire substrate and may be a GaN substrate or the like. Moreover, for the method for producing each semiconductor layer, it is possible to use a publically known production method such for example as a metal organic vapor phase epitaxy (MOVPE) method or a metal organic chemical vapor deposition (MOCVD) method.

Furthermore, while the p-electrode 15 has a multilayer structure, the p-electrode 15 may be configured to contain metals other than Ni and Pt as long as the p-electrode 15 contains a metal such as Ag or Cu that has a possibility of migration. Moreover, for its production method, it is possible to use a publically known production method such for example as a sputtering method or a vacuum deposition method. Stacked layers are formed into a desired pattern by a lift-off method, for example. Conventionally, in consideration of the migration of Ag or the like, a multilayer structure has been employed in which the layers above and below the Ag layer or the like layer are formed from different metals (sandwich structure). However, since the whole element is covered with any one of the protective films of Examples 1 to 3 described above, such a sandwich structure does not necessarily have be to employed in order to sufficiently suppress the migration of Ag or the like.

Moreover, each of the p-pad 16, the n-electrode 17, and the n-pad 18 has a single-layer structure or a multilayer structure. For their production methods, it is possible to use a publically known production method such for example as a sputtering method or a vacuum deposition method. A stacked layer(s) is(are) formed into a desired pattern by a lift-off method, for example, as in the case of the p-electrode 15.

Note that the silicon nitride, as represented by Si₃N₄, could be described as SiₓN_{y} based on its composition ratio, but is described above as SiN for the sake of simple description. Likewise, the silicon oxide, as represented by SiO₂, could be described as SiₓO_{y} based on its composition ratio, but is described above as SiO for the sake of simple description.

### INDUSTRIAL APPLICABILITY

The present invention is designed to be applied to semiconductor light-emitting elements and is preferably applied to white LEDs in particular.

## Claims

1. A protective film for protecting a semiconductor light-emitting element including a plurality of semiconductor layers formed on a substrate and a plurality of electrode portions serving as electrodes of the plurality of semiconductor layers, comprising:
a first protective film and a second protective film as the protective film, the first protective film covering a periphery of the plurality of semiconductor layers and a periphery of the plurality of electrode portions, the second protective film covering a periphery of the first protective film, wherein
the first protective film is made of a silicon nitride and has a film thickness of 35 nm or larger, and
the second protective film is made of a silicon oxide and has a film thickness larger than the film thickness of the first protective film.

2. The protective film of a semiconductor light-emitting element according to claim 1, further comprising:
a third protective film covering a periphery of the second protective film, wherein
the third protective film is made of a silicon nitride and has a film thickness of 35 nm or larger.

3. The protective film of a semiconductor light-emitting element according to claim 2, wherein the second protective film is made of a silicon oxide whose number of Si-OH bonds inside the film is 1.3×10²¹ [bonds/cm³] or smaller, in which case the film thickness of the first protective film is set to 17.5 nm or larger.

4. The protective film of a semiconductor light-emitting element according to any one of claims 1 to 3, wherein at least one of the plurality of electrode portions is made of a metal containing silver.

5. A semiconductor light-emitting element using the protective film of a semiconductor light-emitting element according to any one of claims 1 to 4.

6. A method for producing a protective film for protecting a semiconductor light-emitting element including a plurality of semiconductor layers formed on a substrate and a plurality of electrode portions serving as electrodes of the plurality of semiconductor layers, comprising:
providing a first protective film and a second protective film as the protective film, the first protective film covering a periphery of the plurality of semiconductor layers and a periphery of the plurality of electrode portions, the second protective film covering a periphery of the first protective film, wherein
the first protective film is formed from a silicon nitride to a film thickness of 35 nm or larger, and
the second protective film is formed from a silicon oxide to a film thickness larger than the film thickness of the first protective film.

7. The method for producing a protective film of a semiconductor light-emitting element according to claim 6, further comprising:
providing a third protective film covering a periphery of the second protective film, the third protective film being formed from a silicon nitride to a film thickness of 35 nm or larger.

8. The method for producing a protective film of a semiconductor light-emitting element according to claim 7, wherein the second protective film is formed from a silicon oxide whose number of Si-OH bonds inside the film is 1.3×10²¹ [bonds/cm³] or smaller, in which case the film thickness of the first protective film is set to 17.5 nm or larger.

9. The method for producing a protective film of a semiconductor light-emitting element according to any one of claims 6 to 8, wherein at least one of the plurality of electrode portions is made of a metal containing silver.
